# FASCICULE DE BREVET EUROPEEN

(11) **EP 3 097 563 B1**
(45) Date de publication et mention de la délivrance du brevet: **26.06.2019**
(21) Numéro de dépôt: 14828492.0
(22) Date de dépôt: 15.12.2014
(51) Int. Cl.: G11C 11/16, H01L 43/02, H01L 43/08, H01L 43/12, H01L 27/22, G11C 8/16, G11C 11/56

(54) **MEMOIRE NON VOLATILE MULTIPORT**
NICHTFLÜCHTIGER MULTIPORT-SPEICHER
MULTI-PORT NON-VOLATILE MEMORY

(30) Priorité: 22.01.2014 FR 1450533
(43) Date de publication de la demande: 30.11.2016
(73) Titulaire: Commissariat à l'Energie Atomique et aux Energies Alternatives, 75015 Paris (FR); Centre National de la Recherche Scientifique, 75794 Paris Cedex 16 (FR)
(72) Inventeur: BERNARD-GRANGER, Fabrice, F-38700 Le Sappey En Chartreuse (FR); JAVERLIAC, Virgile, F-38100 Grenoble (FR)
(74) Mandataire: Cabinet Beaumont
(86) Numéro de dépôt international: PCT/FR2014/053336
(87) Numéro de publication internationale: WO 2015/110723

(56) Documents cités:
- FR-A1- 2 970 589
- XIUYUAN BI ET AL: "STT-RAM designs supporting dual-port accesses", DESIGN, AUTOMATION AND TEST IN EUROPE, EDA CONSORTIUM, 111 WEST SAINT JOHN STREET, SUITE 220 SAN JOSE CA 95113 USA, 18 mars 2013 (2013-03-18), pages 853-858, XP058018963, ISBN: 978-1-4503-2153-2 cité dans la demande

## Description

La présente demande de brevet revendique la priorité de la demande de brevet français FR14/50533 qui sera considérée comme faisant partie intégrante de la présente description.

### DOMAINE

La présente description concerne le domaine des mémoires multiports, et en particulier une cellule de mémoire non volatile multiport d'une matrice de mémoire.

### ARRIERE PLAN

On a déjà proposé d'utiliser des éléments magnétorésistifs programmables dans des cellules mémoires pour assurer un stockage de données non volatiles. De tels éléments sont programmables pour prendre l'un de deux états résistifs différents. L'état résistif programmé est conservé même lorsqu'une tension d'alimentation de la cellule mémoire est déconnectée, et ainsi des données peuvent être mémorisées de façon non volatile par de tels éléments.

On a proposé divers type d'éléments magnétorésistifs, dont certains sont aptes à être programmés par la direction d'un courant qu'on fait passer dans l'élément. Un exemple d'un tel élément magnétorésistif programmable par un courant est une jonction tunnel magnétique ayant un mécanisme d'écriture basé sur le principe STT (couple de transfert de spin).

Afin d'augmenter la bande passante des données d'opérations réalisées entre un ou plusieurs processeurs et une mémoire, il a été proposé d'utiliser des mémoires multiports dans lesquelles chaque cellule mémoire peut être lue et écrite en même temps.

Toutefois, il est difficile de prévoir une cellule mémoire non volatile multiport qui soit efficace en termes de consommation d'énergie pendant les opérations d'écriture et/ou qui assure un stockage de données robuste pendant les opérations de lecture.

La publication de Xiuyuan Bi et al. intitulée "STT-RAM Designs supporting dual-port accesses", Design, Automation and Test in Europe, EDA Consortium, 18 mars 2013, pages 853-858, concerne une mémoire de type STT-RAM.

La demande de brevet publiée sous le numéro FR297089 concerne un dispositif mémoire comprenant des éléments à commutation de résistance.

### RESUME

Un objet de modes de réalisation de la présente description est de résoudre au moins partiellement une ou plusieurs difficultés de l'art antérieur.

Selon un aspect, on prévoit une cellule mémoire multiport comprenant : des premier et deuxième éléments magnétorésistifs, chacun étant programmable pour prendre l'un d'au moins deux états résistifs, dans laquelle : le premier élément magnétorésistif est couplé à une première ligne de sortie et est programmable par la direction d'un courant qu'on fait passé dans celui-ci ; et le deuxième élément magnétorésistif est couplé à une deuxième ligne de sortie et est agencé pour être couplé de façon magnétique au premier élément magnétorésistif, le deuxième élément magnétorésistif étant programmable par un champ magnétique généré par le premier élément magnétorésistif.

Selon un mode de réalisation, la cellule mémoire comprend en outre au moins un autre élément magnétorésistif programmable pour prendre l'un d'au moins deux états résistifs, chacun desdits au moins un autre élément magnétorésistif étant agencé pour être programmable par un champ magnétique généré par le premier ou le deuxième élément magnétorésistif.

Selon un mode de réalisation, le deuxième élément magnétorésistif comprend une couche ferromagnétique libre agencée pour être programmée par un champ magnétique généré par une couche ferromagnétique libre du premier élément magnétorésistif, par exemple pendant qu'on fait passer un courant de programmation dans le premier élément magnétorésistif.

Selon un mode de réalisation, la cellule mémoire comprend en outre un guide de flux magnétique agencé pour guider le flux magnétique entre les premier et deuxième éléments magnétorésistifs.

Selon un mode de réalisation, les premier et deuxième éléments magnétorésistifs comprennent des couches ferromagnétiques libres ayant des dimensions différentes entre elles.

Selon un mode de réalisation, la moyenne des résistances des états résistifs du premier élément magnétorésistif est inférieure à celle du deuxième élément magnétorésistif.

Selon un mode de réalisation, chacun des premier et deuxième éléments magnétorésistifs est d'un des types suivants : une jonction tunnel magnétique ayant une anisotropie dans le plan ; et une jonction tunnel magnétique ayant une anisotropie perpendiculaire au plan.

Selon un mode de réalisation, les premier et deuxième éléments magnétorésistifs sont des jonctions tunnels magnétiques ayant une anisotropie dans le plan ; le deuxième élément magnétorésistif est en outre programmable par un courant qu'on fait circuler dans celui-ci ; et le premier élément magnétorésistif est en outre programmable par un champ magnétique généré par le deuxième élément magnétorésistif.

Selon un mode de réalisation, la cellule mémoire comprend en outre au moins un autre élément magnétorésistif programmable pour prendre l'un d'au moins deux états résistifs et les premier, deuxième et au moins un autre éléments magnétorésistifs étant des jonctions tunnels magnétiques ayant une anisotropie dans le plan et disposées selon une ligne.

Selon un mode de réalisation, les premier et deuxième éléments magnétorésistifs sont des jonctions tunnels magnétiques ayant une anisotropie dans le plan, séparées entre elles d'une distance comprise entre 100 et 300 nm.

Selon un mode de réalisation, la cellule mémoire comprend en outre au moins un autre élément magnétorésistif programmable pour prendre l'un d'au moins deux états résistifs, les premier, deuxième et au moins un autre éléments magnétorésistifs sont des jonctions tunnels magnétiques ayant une anisotropie perpendiculaire au plan, et le deuxième et au moins un autre éléments magnétorésistifs sont tous positionnés à égale distance du premier élément magnétorésistif.

Selon un aspect, on prévoit un dispositif mémoire comprenant: une matrice des cellules mémoires susmentionnées ; et un circuit de lecture/écriture adapté à programmer l'état résistif du premier élément magnétorésistif et à lire l'état résistif du deuxième élément magnétorésistif.

Selon un aspect, on prévoit un procédé pour former une cellule mémoire multiport, comprenant: former des premier et deuxième éléments magnétorésistifs, chacun étant programmable pour prendre l'un d'au moins deux états résistifs, les éléments étant séparés d'une distance choisie de telle sorte que le deuxième élément magnétorésistif soit couplé magnétiquement au premier élément magnétorésistif et soit programmable par un champ magnétique généré par le premier élément magnétorésistif ; coupler le premier élément magnétorésistif à une première ligne de sortie ; et coupler le deuxième élément magnétorésistif à une deuxième ligne de sortie.

Selon un mode de réalisation, le procédé comprend en outre le fait de former un guide de flux magnétique pour guider le flux magnétique entre les premier et deuxième éléments magnétorésistifs.

### BREVE DESCRIPTION DES DESSINS

Les caractéristiques et avantages susmentionnés, et d'autres, apparaitront clairement avec la description détaillée suivante de modes de réalisation, faite à titre illustratif et non limitatif, en faisant référence aux dessins joints, dans lesquels:
la figure 1 illustre schématiquement un exemple de cellule mémoire non volatile à double port ;
la figure 2 illustre schématiquement une cellule mémoire non volatile multiport selon un exemple de réalisation de la présente description ;
la figure 3A illustre schématiquement des éléments magnétorésistifs formant la cellule mémoire de la figure 2 selon un exemple de réalisation de la présente description ;
les figures 3B et 3C sont des vues à plat illustrant schématiquement des éléments magnétorésistifs formant la cellule mémoire de la figure 2, selon des exemples de réalisation de la présente description ;
la figure 3D est une vue en perspective illustrant schématiquement des éléments magnétorésistifs formant la cellule mémoire de la figure 2 selon un exemple de réalisation de la présente description ;
la figure 4A est une vue en perspective illustrant schématiquement des éléments magnétorésistifs de la cellule mémoire de la figure 2 selon un autre exemple de réalisation de la présente description ;
la figure 4B est une vue à plat illustrant schématiquement des éléments magnétorésistifs de la cellule mémoire de la figure 2 selon encore un autre exemple de réalisation de la présente description ; et
la figure 5 est un chronogramme représentant des exemples de signaux dans la cellule mémoire de la figure 2 selon un exemple réalisation de la présente description.

### DESCRIPTION DETAILLE

Dans la description suivante, le terme "connecté" est utilisé pour désigner une connexion directe entre un élément et un autre, tandis que le terme "couplé" implique que la connexion entre les deux éléments peut être directe, ou se faire via un élément intermédiaire, comme un transistor, une résistance ou un autre composant.

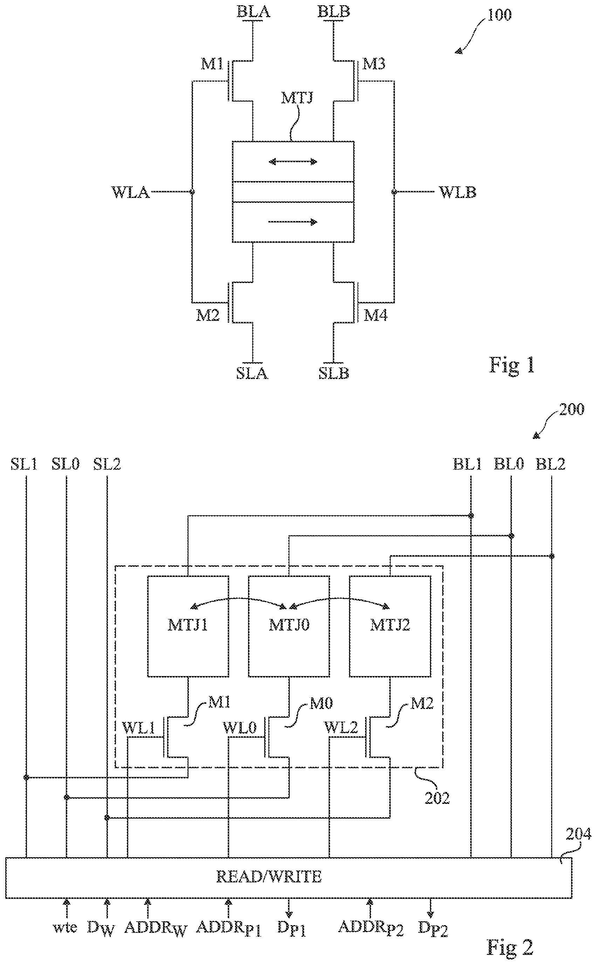

La figure 1 illustre une cellule STT-RAM à double port 100 et reproduit sensiblement la figure 2(a) de la publication intitulée "STT-RAM Designs Supporting Dual-Port Accesses", Xiuyuan Bi et al., Design, Automation and Test in Europe Conférence and Exhibition, 18-22 March 2013, Grenoble, France.

Une jonction tunnel magnétique MTJ comporte quatre bornes. Deux des bornes forment un port A, l'une de ces bornes étant couplée à une ligne de bit BLA par l'intermédiaire d'un transistor M1 et l'autre étant couplée à une ligne de sélection SLA par l'intermédiaire d'un transistor M2. Les transistors M1 et M2 sont contrôlés par une ligne de mot WLA associée au port A. Les deux autres bornes du MTJ forment un port B, l'une de ces bornes étant couplée à une ligne de bit BLB par l'intermédiaire d'un transistor M3 et l'autre étant couplée à une ligne de sélection SLB par l'intermédiaire d'un transistor M4. Les transistors M3 et M4 sont contrôlés par une ligne de mot WLB associée au port B.

Un inconvénient de la cellule STT-RAM 100 de la figure 1 est qu'un courant relativement élevé va être nécessaire pour programmer l'état résistif du MTJ, et que des courants relativement faibles doivent être utilisés par chaque port pour lire l'état résistif du MTJ, puisque sinon il y a un risque que des opérations de lecture reprogramment par inadvertance le MTJ. En outre, si des opérations de lecture sont réalisées par l'intermédiaire des deux ports en même temps, il y un risque d'interférence entre ces opérations, et aussi un risque que l'un des MTJ ou les deux soient écrits. En effet, les deux chemins dans la cellule 100 de la figure 1 sont couplés électriquement par le MTJ.

La figure 2 illustre schématiquement une portion 200 d'un dispositif mémoire comprenant une matrice de cellules mémoires non volatiles multiports 202, dont une seule est illustrée en figure 2.

La cellule mémoire 202 comprend une pluralité d'éléments magnétorésistifs, dans l'exemple de la figure 2 constituée de trois éléments notés MTJO, MTJ1 ET MTJ2. Dans des variantes de réalisation, la cellule mémoire 202 pourrait comprendre seulement deux éléments magnétorésistifs, ou plus de trois de tels éléments.

Chacun des éléments magnétorésistifs est par exemple une jonction tunnel magnétique ayant une résistance qui est programmable par la direction d'un courant qu'on y fait passer. Par exemple, chacun des éléments MTJ0 à MTJ2 est un MTJ qui est écrit sur la base de STT (transfert de couple de spin), et a une anisotropie dans le plan ou perpendiculaire au plan. De tels éléments sont décrits plus en détails dans la publication intitulée "Magnonic spin-transfer torque MRAM with low power, high speed, and error-free switching", N.Mojumder et al., IEDM Tech. Digest (2010), et dans la publication intitulée "Electric toggling of magnets", E. Tsymbal, Natural Materials Vol 11, January 2012.

Quel que soit le type d'élément magnétorésistif, un bit de donnée est par exemple mémorisé de façon non volatile en programmant l'élément de façon à avoir soit une résistance relativement haute (Rₘₐₓ) soit une résistance relativement basse (Rₘᵢₙ). Chacun des éléments magnétorésistifs a par exemple seulement deux états résistifs correspondant aux résistances haute et basse Rₘₐₓ et Rₘᵢₙ, mais les valeurs exactes de Rₘᵢₙ et Rₘₐₓ peuvent varier en fonction de conditions telles que le processus, les matériaux, les variations de température, etc. Les éléments MTJ0 à MTJ2 sont par exemple sélectionnés de telle sorte que Rₘₐₓ soit toujours notablement plus grande que R_{min,} par exemple supérieure d'au moins 20%. En général, le rapport entre la résistance Rₘₐₓ et la résistance Rₘᵢₙ est par exemple compris entre 1,2 et 1000. Rₘᵢₙ est par exemple de l'ordre de 2 kilo-ohms ou moins, et Rₘₐₓ est par exemple de l'ordre de 6 kilo-ohms ou plus, bien que de nombreuses autres valeurs soient possibles.

La cellule mémoire 202 comprend aussi un transistor de sélection couplé en série avec chaque élément magnétorésistif. Par exemple, un transistor M0 contrôlé par un signal de sélection WL0 est couplé entre un noeud de l'élément MTJ0 et une ligne de sélection SL0, un transistor M1 contrôlé par un signal de sélection WL1 est couplé entre un noeud de l'élément MTJ1 et une ligne de sélection SL1, et un transistor M2 contrôlé par un signal de sélection WL2 est couplé entre un noeud de l'élément MTJ2 et une ligne de sélection SL2. Les autres noeuds des éléments MTJ0 à MTJ2 sont par exemple couplés à des lignes de bit BL0 à BL2 respectivement. Les transistors M0 à M2 sont par exemple des transistors NMOS ou des transistors PMOS.

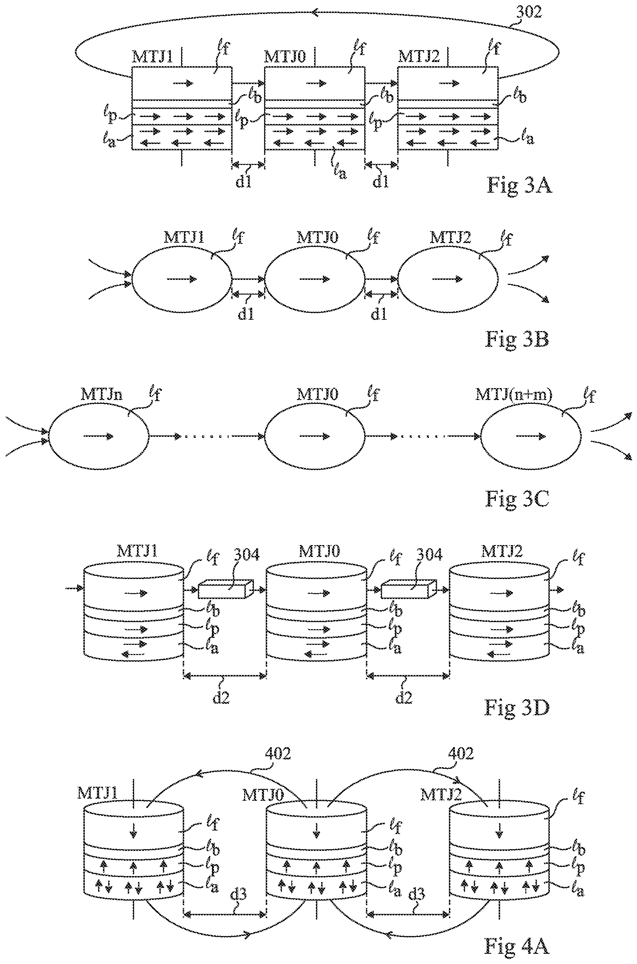

Un circuit de lecture/écriture (READ/WRITE) 204 est utilisé pour programmer l'état résistif des éléments magnétorésistifs MTJ0 à MTJ2. L'élément MTJ0 est représenté positionné entre les éléments MTJ1 et MTJ2 en figure 3, et comme cela est représenté par des flèches s'étendant entre l'élément MTJ0 et les éléments MTJ1 et MTJ2 de chaque côté, il y a un couplage magnétique entre les éléments. Par conséquent, il suffit de programmer l'état résistif de l'élément MTJ0 en appliquant un courant de programmation approprié, et le champ magnétique résultant va faire en sorte que les états résistifs des éléments adjacents MTJ1 et MTJ2 soient aussi programmés en fonction de l'état programmé de l'élément MTJO. Ainsi la même donnée est partagée entre tous les MTJ et peut ensuite être lue à partir de l'un quelconque des éléments MTJ0 à MTJ2.

Le circuit de lecture/écriture 204 comprend par exemple une entrée d'écriture pour recevoir un signal wte indiquant le moment où une opération d'écriture doit être effectuée, une entrée de donnée pour recevoir un signal de donnée D_{W} indiquant la donnée à écrire, une entrée d'adresse d'écriture pour recevoir une adresse d'écriture ADDR_{W} de la cellule mémoire à écrire, une entrée d'adresse de port 1 pour recevoir une adresse ADDR_{P1} de la cellule mémoire à lire par intermédiaire du port 1, une sortie de données du port 1 Dp₁ pour fournir la donnée lue à l'adresse du port 1 ADDR_{P1}, une entrée d'adresse de port 2 pour recevoir une adresse ADDR_{P2} de la cellule mémoire à lire par l'intermédiaire du port 2, et une sortie de donnée du port 2 D_{P2} pour fournir la donnée lue à l'adresse du port 2 ADDR_{P2}. Le port 1 correspond par exemple à l'élément magnétorésistif MTJ1 de chaque cellule mémoire de la matrice, et le port 2 correspond par exemple à l'élément magnétorésistif MTJ2 de chaque cellule mémoire de la matrice.

Dans le mode de réalisation représenté en figure 2, l'élément magnétorésistif MTJ0 est réservé pour les opérations d'écriture. L'élément MTJ0 a par exemple une structure adaptée pour faciliter la programmation de son état résistif par un courant. Par exemple, la moyenne des résistances des états résistifs Rₘᵢₙ, Rₘₐₓ de l'élément MTJ0 est inférieure à celle des éléments MTJ1 et MTJ2, ce qui permet une plus faible consommation d'énergie pour la programmation. En outre, une résistance moyenne plus grande et un différentiel de résistance plus grand entre les états résistifs Rₘᵢₙ et Rₘₐₓ des éléments MTJ1 et MTJ2 facilite le processus de lecture en facilitant la discrimination de l'état Rₘᵢₙ par rapport à l'état Rₘₐₓ.

Dans des variantes de réalisation, les éléments magnétorésistifs MTJO, MTJ1 et MTJ2 ont la même structure et sont tous aptes à être programmés par un courant de programmation appliqué. Dans un tel cas, la cellule mémoire peut être écrite par intermédiaire de l'un quelconque des ports. En outre, le circuit de lecture/écriture 204 comprend ensuite par exemple une entrée d'adresse d'écriture, une entrée de donnée d'écriture, une entrée d'adresse de lecture et une sortie de donnée lue, associées à chaque élément MTJO, MTJ1, MTJ2.

La programmation de l'état résistif de l'élément MTJO, MTJ1 ou MTJ2 suppose l'application d'un courant dans l'élément dans une direction basée sur l'état à programmer. Pour cela, une tension est appliquée, dans une direction basée sur la donnée à écrire, entre la ligne de sélection et la ligne de bit correspondant à l'élément à programmer. Le transistor de sélection correspondant M0, M1 ou M2 est ensuite activé pour provoquer le passage d'un courant dans l'élément MTJO, MTJ1 ou MTJ2 pour programmer son état.

La lecture de l'état résistif programmé de l'élément MTJO, MTJ1 ou MTJ2 implique l'application d'une tension aux bornes de l'élément à lire en utilisant la ligne de sélection correspondante SL0, SL1, SL2 et la ligne de bit correspondante BL0, BL1, BL2, et l'activation du transistor de sélection correspondant M0, M1 ou M2. Le courant résultant est ensuite comparé à un courant de référence, qui est par exemple généré par un dispositif de référence du circuit de lecture/écriture 204 ayant une résistance égale à (Rₘₐₓ + Rₘᵢₙ)/2. Le courant de référence assure un niveau de seuil pour déterminer si l'élément a une résistance programmée de Rₘᵢₙ ou Rₘₐₓ.

La figure 2 illustre une seule cellule mémoire 202, mais il apparaitra clairement à l'homme de l'art comment une pluralité de telles cellules mémoires pourrait être agencées en rangées et en colonnes pour former une matrice. En particulier, il peut y avoir une ou plusieurs cellules mémoires additionnelles dans la même colonne que celle représentée en figure 2, et couplées aux mêmes lignes de sélection SL0 à SL2 et aux mêmes lignes de bit BL0 à BL2. En outre, il pourrait y avoir une ou plusieurs autres colonnes de cellules mémoires ayant d'autres lignes de sélection et d'autres lignes de bit. Les cellules mémoires de la même rangée du réseau mémoire reçoivent par exemple les mêmes signaux de sélection WL0 à WL2.

La figure 3A illustre schématiquement un agencement des éléments MTJO, MTJ1 et MTJ2 de la cellule mémoire 202 de la figure 2 selon un exemple dans lequel il y a des éléments du type STT avec une anisotropie dans le plan. Chaque élément MTJO, MTJ1, MTJ2 est par exemple sensiblement cylindrique, mais a une section qui est non circulaire, par exemple elliptique, ce qui conduit à une augmentation de la stabilité de la rétention des états résistifs lorsque le dispositif est programmé.

La figure 3B est une vue à plat illustrant schématiquement des couches libres l_{f} des éléments MTJ0 à MTJ2 de la figure 3A, et représentant un exemple de leur forme elliptique.

En faisant de nouveau référence à la figure 3A, chaque élément comprend un empilement constitué, du bas vers le haut, d'une couche antiferromagnétique lₐ, d'une couche fixe lₚ, d'une couche de barrière tunnel l_{b} et d'une couche libre l_{f}. En outre, bien que cela ne soit pas illustré en figure 3A, des électrodes peuvent être prévues en haut et en bas de l'empilement pour un contact avec les lignes de connexion.

La couche fixe lₚ forme une couche de référence ayant une direction d'aimantation fixe et est par exemple constituée d'un alliage à base de Co, Fe, Ni et/ou Bo, comme du CoFeBo ou CoFeNi.

La couche antiferromagnétique lₐ est utilisée pour fixer la couche de référence lₚ, et comprend par exemple un alliage à base de Pt, Mn et/ou Ir, comme PtMn ou IrMn.

La couche de barrière tunnel lb est par exemple constituée d'un oxyde tel que AlₓO_{y}, par exemple Al₂O₃ ou MgO.

La couche libre l_{f} a une direction d'aimantation qui peut être programmée. Dans l'exemple de la figure 3A, la direction d'aimantation dans les éléments MTJ0 à MTJ2 a été programmée pour être orientée de la gauche vers la droite dans la figure, qui est la même direction que celle de la couche fixe lₚ, ce qui a pour résultat un état résistif programmé de Rₘᵢₙ. Une programmation opposée correspondrait à une direction d'aimantation dans la couche libre orientée de la droite vers la gauche dans la figure, ce qui aurait pour résultat un état résistif programmé de Rₘₐₓ. La couche libre est par exemple constituée d'un alliage à base de Co, Fe, Ni et/ou Bo, comme du CoFeBo ou du CoFeNi. Ainsi la couche libre l_{f} est utilisée pour générer le champ magnétique responsable du couplage magnétique entre les divers MTJ adjacents.

Comme cela est représenté par une flèche 302 en figure 3A, les éléments MTJ0 à MTJ2 sont agencés de telle sorte que le champ magnétique généré par l'aimantation des couches libres forme une boucle passant à travers la couche libre l_{f} de chacun des éléments. De cette façon, les éléments sont couplés magnétiquement entre eux, et tous les éléments sont programmés dans la même direction.

Un tel couplage magnétique est par exemple obtenu en alignant entres elles les couches libres l_{f} de chacun des éléments et en séparant les éléments adjacents par une distance d1. En général, la distance d1 est par exemple comprise entre 100 et 300 nm. La distance dépend des dimensions des éléments MTJ0 à MTJ2. Par exemple, en supposant que les éléments ont une forme elliptique ayant un facteur de forme longueur/largeur compris entre 1,5 et 3, une longueur comprise entre 20 et 100 nm, une épaisseur de la couche libre l_{f} comprise entre 2 et 5 nm, une épaisseur de la couche barrière l_{b} comprise entre 1 et 2 nm, une épaisseur de la couche fixe lₚ comprise entre 2 et 5 nm, et une épaisseur de la couche antiferromagnétique lₐ comprise entre 2 et 5 nm, la distance d1 est par exemple comprise entre 100 et 200 nm.

La figure 3C est une vue à plat similaire à celle de la figure 3B, mais qui illustre le cas dans lequel il y a une chaine comprenant plus de trois éléments magnétorésistifs. En particulier, il y a n éléments MTJ1 à MTJn disposés à gauche de l'élément MTJO, et m éléments MTJ(n+1) à MTJ(n+m) disposés à droite de l'élément MTJ0. Les variables n et m pourraient chacune être un entier quelconque supérieur à 1, et n'ont pas besoin d'être égales. Le nombre maximum d'éléments qu'on peut programmer par la programmation d'un seul élément de la chaine va dépendre de facteurs comme les dimensions des éléments, la distance entre les éléments, et le niveau de courant utilisé pendant l'opération de programmation.

La figure 3D est une vue en perspective des éléments MTJO, MTJ1 et MTJ2 illustrant un mode de réalisation dans lequel un guide de flux magnétique 304 est disposé entre les couches libres l_{f} d'éléments adjacents et est aligné avec celles-ci. Un tel guide de flux 304 améliore le couplage magnétique entre les MTJ. Par exemple, il a une section rectangulaire, avec une hauteur et une profondeur choisies sur la base des dimensions des couches libres l_{f}. En variante, il pourrait avoir une forme polygonale ou ellipsoïdale. La longueur de chaque guide de flux 304 est par exemple comprise entre 100 et 200 nm, ce qui permet d'augmenter la distance d2 séparant des éléments adjacents en figure 3D à une valeur comprise entre 200 et 500 nm. Le guide 304 est par exemple constitué d'un alliage permalloy comme le Ni₈₀Fe₂₀.

La figure 4A est une vue en perspective illustrant les éléments magnétorésistifs MTJ0 à MTJ2 de la figure 2 selon une variante de réalisation par rapport à celle de la figure 3A, dans laquelle les éléments sont du type STT avec une anisotropie magnétique perpendiculaire au plan. Les éléments MTJ0 à MTJ2 de la figure 4A sont sensiblement cylindriques, et ont par exemple des sections circulaires.

Comme pour les éléments de la figure 3A, chaque élément de la figure 4A comprend un empilement constitué, du bas vers le haut, d'une couche antiferromagnétique lₐ, d'une couche fixe lₚ, d'une couche de barrière tunnel l_{b} et d'une couche libre l_{f}. Ces couches peuvent être formées avec les mêmes listes de matériaux décrites précédemment en relation avec la figure 3A. En outre, bien que cela ne soit pas illustré en figure 3A, des électrodes peuvent être prévues en haut et en bas de l'empilement pour un contact avec les lignes de connexion.

La couche fixe lₚ de chaque élément a par exemple une direction d'aimantation orientée vers le haut, comme cela est représenté par des flèches vers le haut en figure 4A. La couche libre l_{f} de l'élément MTJ0 est par exemple programmée pour avoir la même direction d'aimantation que les couches fixes lₚ, et le champ magnétique résultant représenté par des boucles 402 en figure 4A fait en sorte que les éléments MTJ1 et MTJ2 ont des directions d'aimantation orientées vers le bas dans leurs couches libres l_{f} dans la direction opposés à celle des couches fixes lₚ. La couche libre l_{f} de l'élément MTJ0 peut être programmée dans la direction opposée pour avoir une direction d'aimantation orientée vers le bas, auquel cas le champ magnétique 402 sera dans la direction opposée, ce qui fait en sorte que les éléments MTJ1 et MTJ2 ont des directions d'aimantation vers le haut dans leurs couches libres l_{f}.

La distance d3 séparant des éléments MJT0 à MTJ2 adjacents en figure 4A est choisie de façon à provoquer un couplage magnétique entre les éléments, et va dépendre de l'intensité d'aimantation résultant de facteurs tels que les dimensions des éléments. Par exemple, en supposant que les éléments ont chacun un diamètre compris entre 20 et 100 nm, une épaisseur de la couche libre l_{f} comprise entre 2 et 5 nm, une épaisseur de la couche barrière l_{b} comprise entre 1 et 2 nm, une épaisseur de la couche fixe lₚ comprise entre 2 et 5 nm, et une épaisseur de la couche antiferromagnétique lₐ comprise entre 2 et 5 nm, la distance d3 est par exemple égale à environ 100 nm.

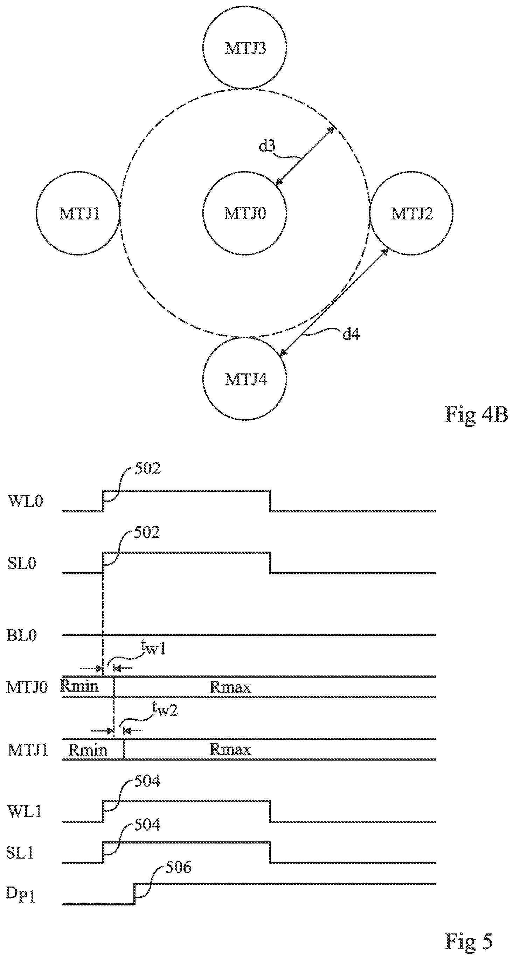

La figure 4B est une vue à plat d'un agencement d'éléments magnétorésistifs du type STT ayant une anisotrope magnétique perpendiculaire au plan selon un autre exemple dans lequel il y a cinq éléments, l'élément MTJ0 étant placé au centre, et les quatre autres éléments MTJ1 à MTJ4 formant un cercle autour de l'élément MTJO, chacun étant à égale distance de l'élément MTJ0. En particulier, chaque élément MTJ1 à MTJ4 a par exemple son bord intérieur aligné sur un cercle représenté par une ligne en pointillé en figure 4B, qui est à une distance d3 du bord extérieur de l'élément MTJO, par exemple égale à environ 100 nm. La distance d4 séparant les éléments adjacents MTJ1 à MTJ4 est par exemple notablement supérieure à d3 afin d'éviter un couplage magnétique entre ces éléments. Dans des variantes de réalisation il pourrait y avoir plus de quatre éléments positionnés autour de l'élément central MTJO, par exemple cinq ou six de ces éléments.

La figure 5 est un chronogramme illustrant un exemple des signaux WL0, SL0, BL0, des états résistifs des éléments MTJO, MTJ1, et des signaux WL1, SL1 et Dp₁ de la figure 2 pendant une opération d'écriture de l'élément MTJ0 et une opération de lecture de l'élément MTJ1.

Des fronts montant 502 des signaux WL0 et SL0 lancent par exemple l'opération d'écriture en provoquant le passage d'un courant de programmation dans l'élément MTJ0. La densité de courant de programmation a par exemple un niveau de l'ordre de 10⁶ A/cm². Cela provoque un changement rapide de l'état résistif de l'élément MTJO, dans cet exemple d'une résistance Rₘᵢₙ à une résistance Rₘₐₓ après un temps d'écriture de t_{w1}. Ce temps d'écriture est par exemple de l'ordre de 0,1 à 10 ns. Le nouvel état programmé de l'élément MTJ0 provoque ensuite la programmation de l'élément MTJ1 en raison du couplage magnétique entre les couches libres des éléments MTJ0 et MTJ1. Ainsi, après un temps d'écriture t_{w2} à partir du changement de l'état résistif de l'élément MTJO, l'état résistif de l'élément MTJ1 change aussi. Le temps d'écriture t_{w2} est par exemple de l'ordre de 1 à 100 ps.

Dans l'exemple de la figure 5, les éléments MTJ0 et MTJ1 sont du type STT avec une anisotropie magnétique dans le plan, et ainsi l'état résistif de l'élément MTJ1 change aussi de Rₘᵢₙ à Rₘₐₓ. Autrement, si les éléments MTJ0 et MTJ1 sont du type STT avec une anisotropie magnétique perpendiculaire au plan, l'élément MTJ1 va avoir la programmation opposée, passant de l'état résistif Rₘₐₓ à l'état résistif Rₘᵢₙ.

Comme cela est représenté par des fronts montants 504 des signaux WL1 et SL1, une opération de lecture de l'élément MTJ1 est par exemple réalisée en même temps que l'opération d'écriture de l'élément MTJ0. Les opérations d'écriture des éléments MTJO, MTJ1 étant très rapides, l'opération de lecture est capable de détecter le nouvel état programmé de l'élément MTJ1, et le signal de donnée Dₚ₁ change ainsi peu de temps après pour passer à un niveau haut comme cela est représenté par le front montant 506, qui est supposé correspondre à un état résistif Rₘₐₓ.

Un avantage des modes de réalisation décrits ici est de prévoir une cellule mémoire multiport qui peut être programmée de façon simple. En outre, puisque les éléments magnétorésistifs formant chaque cellule mémoire restent isolés électriquement entre eux, il y a peu de risque que de multiples opérations de lecture affectent les états programmés des éléments, ce qui conduit à une mémorisation de données robuste. En outre, il est possible de réaliser une opération de lecture pendant le même cycle qu'une opération d'écriture de la même cellule, ce qui conduit à un temps d'accès réduit. Encore un autre avantage est qu'il est possible d'ajuster les matériaux et/ou la forme des MTJ de telle sorte qu'un ou plusieurs MTJ de chaque cellule soient adaptés à des opérations de lecture, et un ou plusieurs autres MTJ de chaque cellule soient adaptés à des opérations d'écriture.

Avec la description ainsi faite d'au moins un mode réalisation illustratif, diverses altérations, modifications, et améliorations apparaitront à l'homme de l'art.

Par exemple, il sera clair pour l'homme de l'art que bien que certains exemples de dimensions et d'agencements de dispositifs magnétorésistifs aient été décrits, il y a de nombreuses variantes de réalisation qui pourraient être utilisées. Par exemple, de tels modes de réalisation pourraient être déterminés en résolvant des équations de Maxwell et en simulant le comportement de matériaux micro-magnétiques en utilisant un ou plusieurs des outils suivants (les divers noms peuvent correspondre à des marques déposées):
- Flux 3D de la compagnie CEDRAT (http://www.cédrat.com/fr/logiciels/flux.html);
- Comsol Multiphysics ® from the company COMSOL (http://www.comsol.com/model/the-magnetic-field-from-a-permanent-magnet-78);
- OOmmF (open source code) (http://math.nist.gov/oommf/); et
- Fastmag from the University of California, San Diego (http://cem.ucsd.edu/index_files/fastmag.html).

En outre, il sera clair pour l'homme de l'art que, dans les modes de réalisation décrits ici, les transistors NMOS pourraient être remplacés par des transistors PMOS et vice versa, et bien qu'on ait décrit des transistors basés sur la technologie MOS, dans des variantes de réalisation on pourrait utiliser d'autres technologies de transistors, comme la technologie bipolaire.

En outre, il sera clair pour l'homme de l'art que les divers éléments décrits en relation avec les divers modes de réalisation pourraient être combinés, dans des variantes de réalisation, selon des combinaisons quelconques.

## Revendications

1. Cellule mémoire multiport comprenant :
des premier et deuxième éléments magnétorésistifs (MTJO, MTJ1), chacun étant programmable pour prendre l'un d'au moins deux états résistifs (Rₘᵢₙ, Rₘₐₓ), dans laquelle :
le premier élément magnétorésistif (MTJ0) est couplé à une première ligne de sortie (BL0) et est programmable par la direction d'un courant qu'on fait passer dans celui-ci ; et
le deuxième élément magnétorésistif (MTJ1) est couplé à une deuxième ligne de sortie (BL1) et est agencé pour être couplé de façon magnétique au premier élément magnétorésistif (MTJO), le deuxième élément magnétorésistif (MTJ1) étant programmable par un champ magnétique généré par le premier élément magnétorésistif.

2. Cellule mémoire selon la revendication 1, comprenant en outre au moins un autre élément magnétorésistif (MTJ2) programmable pour prendre l'un d'au moins deux états résistifs (Rₘᵢₙ, Rₘₐₓ), chacun desdits au moins un autre élément magnétorésistif (MTJ2) étant agencé pour être programmable par un champ magnétique généré par le premier ou le deuxième élément magnétorésistif (MTJO, MTJ1).

3. Cellule mémoire selon les revendications 1 ou 2, dans laquelle le deuxième élément magnétorésistif (MTJ1) comprend une couche ferromagnétique libre (l_{f}) agencée pour être programmée par un champ magnétique généré par une couche ferromagnétique libre (l_{f}) du premier élément magnétorésistif (MTJ0).

4. Cellule mémoire selon l'une quelconque des revendications 1 à 3, comprenant en outre un guide de flux magnétique (304) agencé pour guider le flux magnétique entre les premier et deuxième éléments magnétorésistifs (MTJO, MTJ1).

5. Cellule mémoire selon l'une quelconque des revendications 1 à 4, dans laquelle les premier et deuxième éléments magnétorésistifs (MTJO, MTJ1) comprennent des couches ferromagnétiques libres (l_{f}) ayant des dimensions différentes entre elles.

6. Cellule mémoire selon l'une quelconque des revendications 1 à 5, dans laquelle la moyenne des résistances des états résistifs (R_{min,} Rₘₐₓ) du premier élément magnétorésistif (MTJ0) est inférieure à celle du deuxième élément magnétorésistif (MTJ1).

7. Cellule mémoire selon l'une quelconque des revendications 1 à 6, dans laquelle chacun des premier et deuxième éléments magnétorésistifs (MTJO, MTJ1) est de l'un des types suivants :
une jonction tunnel magnétique ayant une anisotropie dans le plan ; et
une jonction tunnel magnétique ayant une anisotropie perpendiculaire au plan.

8. Cellule mémoire selon l'une quelconque des revendications 1 à 7, dans laquelle :
les premier et deuxième éléments magnétorésistifs (MTJO, MTJ1) sont des jonctions tunnels magnétiques ayant une anisotropie dans le plan ;
le deuxième élément magnétorésistif (MTJ1) est en outre programmable par un courant qu'on fait circuler dans celui-ci ; et
le premier élément magnétorésistif (MJT0) est en outre programmable par un champ magnétique généré par le deuxième élément magnétorésistif (MTJ1).

9. Cellule mémoire selon l'une quelconque des revendications 1 à 8, comprenant en outre au moins un autre élément magnétorésistif (MTJ2) programmable pour prendre l'un d'au moins deux états résistifs (R_{min,} Rₘₐₓ), et dans laquelle les premier, deuxième, et au moins un autre éléments magnétorésistifs sont des jonctions tunnels magnétiques ayant une anisotropie dans le plan et disposées selon une ligne.

10. Cellule mémoire selon l'une quelconque des revendications 1 à 9, dans laquelle les premier et deuxième éléments magnétorésistifs (MTJO, MTJ1) sont des jonctions tunnels magnétiques ayant une anisotropie dans le plan, séparées entre elles d'une distance (d1) comprise entre 100 et 300 nm.

11. Cellule mémoire selon l'une quelconque des revendications 1 à 7, comprenant en outre au moins un autre élément magnétorésistif (MTJ2) programmable pour prendre l'un d'au moins deux états résistifs (Rₘᵢₙ, Rₘₐₓ), et dans laquelle les premier, deuxième et au moins un autre éléments magnétorésistifs sont des jonctions tunnels magnétiques ayant une anisotropie perpendiculaire au plan, et dans laquelle le deuxième et au moins un autre éléments magnétorésistifs sont tous positionnés à égale distance (d3) du premier élément magnétorésistif (MTJ0).

12. Dispositif mémoire comprenant :
une matrice des cellules mémoires de l'une quelconque des revendications 1 à 11 ; et
un circuit de lecture/ écriture (204) adapté à programmer l'état résistif du premier élément magnétorésistif (MTJ0) et à lire l'état résistif du deuxième élément magnétorésistif (MTJ1).

13. Procédé pour former une cellule mémoire multiport, comprenant :
former des premier et deuxième éléments magnétorésistifs (MTJO, MTJ1), chacun étant programmable pour prendre l'un d'au moins deux états résistifs (R_{min,} Rₘₐₓ), les éléments étant séparés d'une distance (d1, d2, d3) choisie de telle sorte que le deuxième élément magnétorésistif (MTJ1) soit couplé magnétiquement au premier élément magnétorésistif (MTJ0) et soit programmable par un champ magnétique généré par le premier élément magnétorésistif (MTJ0) ;
coupler le premier élément magnétorésistif (MTJ0) à une première ligne de sortie (BL0) ; et
coupler le deuxième élément magnétorésistif (MTJ1) à une deuxième ligne de sortie (BL1).

14. Procédé selon la revendication 13, comprenant en outre le fait de former un guide de flux magnétique (304) pour guider le flux magnétique entre les premier et deuxième éléments magnétorésistifs (MTJO, MTJ1).

## Patentansprüche

1. Multiport- bzw. Mehrkanalspeicherzelle, die Folgendes aufweist:
erste und zweite magnetoresistive Elemente (MTJO, MTJ1), die jeweils programmierbar sind, um einen von wenigstens zwei Widerstandszuständen (Rₘᵢₙ, Rₘₐₓ) zu haben, wobei:
das erste magnetoresistive Element (MTJ0) mit einer ersten Ausgangsleitung (BL0) gekoppelt ist und durch die Richtung eines dort hindurch fließenden Stroms programmierbar ist; und
das zweite magnetoresistive Element (MTJ1) mit einer zweiten Ausgangsleitung (BL1) gekoppelt ist und magnetisch mit dem ersten magnetoresistiven Element (MTJ0) gekoppelt werden kann, wobei das zweite magnetoresistive Element (MTJ1) durch ein Magnetfeld programmierbar ist, das durch das erste magnetoresistive Element erzeugt wird.

2. Speicherzelle nach Anspruch 1, die ferner wenigstens ein weiteres magnetoresistives Element (MTJ2) auweist, das programmierbar ist, um einen von wenigstens zwei Widerstandszuständen (Rₘᵢₙ, Rₘₐₓ) zu haben, wobei jedes der wenigstens einen weiteren magnetoresistiven Elemente (MTJ2) angeordnet ist, um durch ein Magnetfeld programmierbar zu sein, das durch das erste oder zweite magnetoresistive Element (MTJO, MTJ1) erzeugt wird.

3. Speicherzelle nach Anspruch 1 oder 2, wobei das zweite magnetoresistive Element (MTJ1) eine freie ferromagnetische Schicht (l_{f}) aufweist, die angeordnet ist, um durch ein Magnetfeld programmiert zu werden, das durch eine freie ferromagnetische Schicht (l_{f}) des ersten magnetoresistiven Elements (MTJ0) erzeugt wird.

4. Speicherzelle nach einem der Ansprüche 1 bis 3, die ferner eine Magnetflussführung (304) aufweist, die angeordnet ist, um den Magnetfluss zwischen den ersten und zweiten magnetoresistiven Elementen (MTJO, MTJ1) zu führen.

5. Speicherzelle nach einem der Ansprüche 1 bis 4, wobei die ersten und zweiten magnetoresistiven Elemente (MTJO, MTJ1) freie ferromagnetische Schichten (l_{f}) mit unterschiedlichen Abmessungen voneinander aufweisen.

6. Speicherzelle nach einem der Ansprüche 1 bis 5, wobei der durchschnittliche Widerstand der Widerstandszustände (Rₘᵢₙ, Rₘₐₓ) des ersten magnetoresistiven Elements (MTJ0) niedriger ist als der des zweiten magnetoresistiven Elements (MTJ1).

7. Speicherzelle nach einem der Ansprüche 1 bis 6, wobei jedes der ersten und zweiten magnetoresistiven Elemente (MTJO, MTJ1) eines der Folgenden ist:
ein Magnet-Tunnelübergang mit Anisotropie in der Ebene; und
ein Magnet-Tunnelübergang mit senkrecht zur Ebene verlaufender Anisotropie.

8. Speicherzelle nach einem der Ansprüche 1 bis 7, wobei:
die ersten und zweiten magnetoresistiven Elemente (MTJO, MTJ1) Magnet-Tunnelübergange mit Anisotropie in der Ebene sind;
das zweite magnetoresistive Element (MTJ1) ferner durch einen dort hindurchfließenden Strom programmierbar ist; und
das erste magnetoresistive Element (MTJ0) ferner durch ein Magnetfeld programmierbar ist, das durch das zweite magnetoresistive Element (MTJ1) erzeugt wird.

9. Speicherzelle nach einem der Ansprüche 1 bis 8, die ferner wenigstens ein weiteres magnetoresistives Element (MTJ2) aufweist, das programmierbar ist, um einen von wenigstens zwei Widerstandszuständen (Rₘᵢₙ, Rₘₐₓ) zu haben, und wobei das erste, zweite und wenigstens ein weiteres magnetoresistive Element Magnet-Tunnelübergänge mit in der Ebene angeordneter Anisotropie in einer Reihe angeordnet sind.

10. Speicherzelle nach einem der Ansprüche 1 bis 9, wobei das erste und das zweite magnetoresistive Element (MTJO, MTJ1) Magnet-Tunnelübergangen mit Anisotropie in der Ebene sind, die durch einen Abstand (d1) zwischen 100 und 300 nm voneinander getrennt sind.

11. Speicherzelle nach einem der Ansprüche 1 bis 7, die ferner wenigstens ein weiteres magnetoresistives Element (MTJ2) aufweist, das programmierbar ist, um einen von wenigstens zwei Widerstandszuständen (Rₘᵢₙ, Rₘₐₓ) zu haben, und wobei das erste, zweite und wenigstens ein weiteres magnetoresistives Element Magnet-Tunnelübergänge mit senkrecht zur Ebene stehender Anisotropie sind, und wobei das zweite und wenigstens ein weiteres magnetoresistives Element jeweils in einem gleichen Abstand (d3) von dem ersten magnetoresistiven Element (MTJ0) positioniert sind.

12. Speichervorrichtung, die Folgendes aufweist:
eine Anordnung der Speicherzellen nach einem der Ansprüche 1 bis 11; und
eine Lese-/Schreibschaltung (204), die geeignet ist, um den Widerstandszustand des ersten magnetoresistiven Elements (MTJ0) zu programmieren und den Widerstandszustand des zweiten magnetoresistiven Elements (MTJ1) zu lesen.

13. Verfahren zum Bilden einer Multiport-Speicherzelle, das Folgendes aufweist:
Bilden von ersten und zweiten magnetoresistiven Elementen (MTJO, MTJ1), die jeweils programmierbar sind, um einen von wenigstens zwei Widerstandszuständen (Rₘᵢₙ, Rₘₐₓ) zu haben, wobei die Elemente durch einen Abstand (d1, d2, d3) getrennt sind, der so gewählt ist, dass das zweite magnetoresistive Element (MTJ1) magnetisch mit dem ersten magnetoresistiven Element (MTJ0) gekoppelt und durch ein Magnetfeld programmierbar ist, das durch das erste magnetoresistive Element (MTJ0) erzeugt wird;
Koppeln des ersten magnetoresistiven Elements (MTJ0) mit einer ersten Ausgangsleitung (BLO); und
Koppeln des zweiten magnetoresistiven Elements (MTJ1) mit einer zweiten Ausgangsleitung (BL1).

14. Verfahren nach Anspruch 13, das ferner das Bilden einer Magnetflussführung (304) zum Führen des Magnetflusses zwischen den ersten und zweiten magnetoresistiven Elementen (MTJO, MTJ1) aufweist.

## Claims

1. A multiport memory cell comprising:
first and second magnetoresistive elements (MTJO, MTJ1) each programmable to have one of at least two resistive states (R_{min,} Rₘₐₓ), wherein:
the first magnetoresistive element (MTJ0) is coupled to a first output line (BL0) and is programmable by the direction of a current passed through it; and
the second magnetoresistive element (MTJ1) is coupled to a second output line (BL1) and is arranged to be magnetically coupled to the first magnetoresistive element (MTJO), the second magnetoresistive element (MTJ1) being programmable by a magnetic field generated by the first magnetoresistive element.

2. The memory cell of claim 1, further comprising at least one further magnetoresistive element (MTJ2) programmable to have one of at least two resistive states (R_{min,} Rₘₐₓ), wherein each of the at least one further magnetoresistive element (MTJ2) is arranged to be programmable by a magnetic field generated by the first or second magnetoresistive element (MTJO, MTJ1).

3. The memory cell of claim 1 or 2, wherein said second magnetoresistive element (MTJ1) comprises a free ferromagnetic layer (l_{f}) arranged to be programmed by a magnetic field generated by a free ferromagnetic layer (l_{f}) of the first magnetoresistive element (MTJ0).

4. The memory cell of any of claims 1 to 3, further comprising a magnetic flux guide (304) arranged to guide magnetic flux between the first and second magnetoresistive elements (MTJO, MTJ1).

5. The memory cell of any of claims 1 to 4, wherein said first and second magnetoresistive elements (MTJO, MTJ1) comprise free ferromagnetic layers (l_{f}) of different dimensions from each other.

6. The memory cell of any of claims 1 to 5, wherein the average resistance of the resistive states (R_{min,} Rₘₐₓ) of the first magnetoresistive element (MTJ0) is lower than that of the second magnetoresistive element (MTJ1).

7. The memory cell of any of claims 1 to 6, wherein each of the first and second magnetoresistive elements (MTJO, MTJ1) is one of:
a magnetic tunnel junction with in-plane anisotropy; and
a magnetic tunnel junction with perpendicular-to-plane anisotropy.

8. The memory cell of any of claims 1 to 7, wherein:
the first and second magnetoresistive elements (MTJO, MTJ1) are magnetic tunnel junctions with in-plane anisotropy;
the second magnetoresistive element (MTJ1) is further programmable by a current passed through it; and
the first magnetoresistive element (MTJ0) is further programmable by a magnetic field generated by the second magnetoresistive element (MTJ1).

9. The memory cell of any of claims 1 to 8, further comprising at least one further magnetoresistive element (MTJ2) programmable to have one of at least two resistive states (Rₘᵢₙ, Rₘₐₓ), and wherein the first, second and at least one further magnetoresistive elements are magnetic tunnel junctions with in-plane anisotropy arranged in a line.

10. The memory cell of any of claims 1 to 9, wherein the first and second magnetoresistive elements (MTJO, MTJ1) are magnetic tunnel junctions with in-plane anisotropy separated from each other by a distance (d1) of between 100 and 300 nm.

11. The memory cell of any of claims 1 to 7, further comprising at least one further magnetoresistive element (MTJ2) programmable to have one of at least two resistive states (Rₘᵢₙ, Rₘₐₓ), and wherein the first, second and at least one further magnetoresistive elements are magnetic tunnel junctions with perpendicular-to-plane anisotropy, and wherein the second and at least one further magnetoresistive elements are each positioned an equal distance (d3) from said first magnetoresistive element (MTJ0).

12. A memory device comprising:
an array of the memory cells of any of claims 1 to 11; and
a read/write circuit (204) adapted to program the resistive state of said first magnetoresistive element (MTJ0) and read the resistive state of said second magnetoresistive element (MTJ1).

13. A method of forming a multiport memory cell comprising:
forming first and second magnetoresistive elements (MTJO, MTJ1) each programmable to have one of at least two resistive states (Rₘᵢₙ, Rₘₐₓ), the elements being separated by a distance (d1, d2, d3) chosen such that the second magnetoresistive element (MTJ1) is magnetically coupled to the first magnetoresistive element (MTJ0) and is programmable by a magnetic field generated by the first magnetoresistive element (MTJ0);
coupling the first magnetoresistive element (MTJ0) to a first output line (BL0); and
coupling the second magnetoresistive element (MTJ1) to a second output line (BL1).

14. The method of claim 13, further comprising forming a magnetic flux guide (304) for guiding magnetic flux between the first and second magnetoresistive elements (MTJO, MTJ1).
